# EUROPEAN PATENT SPECIFICATION

(11) **EP 4 249 633 B1**
(45) Date of publication and mention of the grant of the patent: **27.08.2025**
(21) Application number: 21893925.4
(22) Date of filing: 17.11.2021
(51) Int. Cl.: C23C 16/40, C23C 16/455, C23C 16/505, C23C 16/509, C23C 16/52, H01J 37/32, G01B 11/06, H01L 21/67

(54) **SEMICONDUCTOR PROCESSING DEVICE, REACTION CHAMBER THEREOF, AND FILM LAYER DEPOSITION METHOD**
HALBLEITERVERARBEITUNGSVORRICHTUNG, REAKTIONSKAMMER DAFÜR UND VERFAHREN ZUR FILMSCHICHTABSCHEIDUNG
DISPOSITIF DE TRAITEMENT DE SEMI-CONDUCTEUR, SA CHAMBRE DE RÉACTION ET PROCÉDÉ DE DÉPÔT DE COUCHE DE FILM

(30) Priority: 18.11.2020 CN 202011296600
(43) Date of publication of application: 27.09.2023
(73) Proprietor: Beijing NAURA Microelectronics Equipment Co., Ltd., Beijing 100176 (CN)
(72) Inventor: QIN, Haifeng, Beijing 100176 (CN); LAN, Yunfeng, Beijing 100176 (CN); SHI, Shuaitao, Beijing 100176 (CN); WANG, Huanyu, Beijing 100176 (CN); ZHANG, Fang, Beijing 100176 (CN); ZHANG, Wenqiang, Beijing 100176 (CN)
(74) Representative: Cohausz & Florack
(86) International application number: PCT/CN2021/131150
(87) International publication number: WO 2022/105778

(56) References cited:
- WO-A2-2020/167601
- WO-A2-2020/167601
- CN-A- 103 031 546
- CN-A- 104 947 040
- CN-A- 106 567 044
- CN-A- 110 582 155
- CN-A- 112 458 440
- CN-U- 208 949 405
- CN-U- 208 949 405
- KR-A- 20140 136 154
- US-A- 4 166 784
- US-A- 5 846 373
- US-A- 5 846 373
- US-A1- 2011 293 854
- US-B2- 9 666 417

## Description

### Field

The present disclosure relates to the technical field of semiconductor processing, in particular to a reaction chamber of a semiconductor process device, the semiconductor process device and a film layer deposition method.

### Background

A silicon dioxide (SiO₂) thin film is one of the most commonly used films in a semiconductor process, traditional methods of deposition of the SiO₂ thin film, such as an oxidation process, need to be performed in a high-temperature environment, the temperature usually exceeds 1000°C, and the high temperature may produce adverse byproducts, thus affecting a coverage rate of the thin film.

A plasma enhanced atomic layer deposition (hereinafter referred to as PEALD) method may deposit a SiO₂ thin film in a low-temperature environment, and the temperature is usually 70°C-300°C. Compared with the oxidation process, the PEALD method has a better coverage rate of thin films, and more precisely controls thicknesses of the thin films.

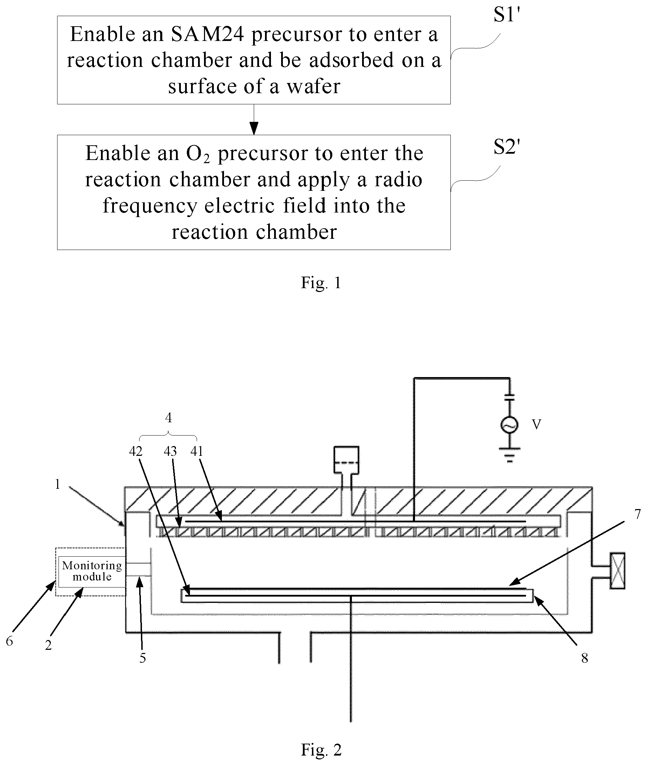

At present, adopting the PEALD method to deposit a SiO₂ thin film, bis(diethylamine)silane (SAM24) and oxygen (O₂) are usually adopted to serve as precursors. Fig. 1 is a flow block diagram of adopting a traditional PEALD method to deposit a SiO₂ thin film. As shown in Fig. 1, a deposition process at least includes: step S1', enabling a SAM24 precursor to enter a reaction chamber and be adsorbed on a surface of a wafer; and step S2', enabling an O₂ precursor to enter the reaction chamber, applying a radio frequency electric field into the reaction chamber, so as to break macromolecules of SAM24 into micromolecules, motivating oxygen molecules to form active oxygen atoms, oxygen radicals and other multiple active groups, and enabling the broken micromolecules of the SAM24 to react with the active groups of oxygen to form a SiO₂ thin film. The above process is used as one cycle, however, multiple cycles usually need to be repeated in the practical process, such that a thickness of the formed SiO₂ thin film meets practical requirements.

However, when applying the radio frequency electric field into the reaction chamber, ignition delay, and even abnormalities such as ignition failures may occur, as long as an abnormal cycle occurs in the multiple cycles, it may lead to a deviation between the thickness of the formed SiO₂ thin film and a target thickness, and then lead to poor consistency between thicknesses of films, affecting the product quality.

WO 2020/167601 A2 relates to a PEALD apparatus in which the frequency or magnitude of the RF power is adjusted when a plasma glow abnormality occurs.

### Summary

The present disclosure aims to at least solve one of technical problems existing in the prior art, and provides a reaction chamber of a semiconductor process device, the semiconductor process device and a film layer deposition method as disclosed in claims 1-10.

The present disclosure has the beneficial effects:
in the technical solutions of the semiconductor process device and the reaction chamber thereof and the film layer deposition method provided by the present disclosure, the monitoring module monitors the brightness of the plasma light source generated in the chamber body when the deposition module executes each deposition step, and generates the first signal according to the brightness of the plasma light source; and the control module judges whether the thickness of the target film layer obtained after executing the multiple deposition steps is abnormal according to the above first signal corresponding to at least one of the deposition steps, and if yes, executes the abnormality processing flow. Therefore, abnormality processing may be performed in time after the thickness of the target film layer is abnormal, and then a deviation between the thickness of the target film layer and the target thickness can be improved.

### Brief Description of the Drawings

Accompanying drawings are used to provide a further understanding of the present disclosure, constitute one part of the specification, are used for explaining the present disclosure with specific implementations below, but do not constitute a limitation to the present disclosure. In the drawings:
Fig. 1 is a flow diagram of depositing a SiO₂ thin film by traditional PEALD.
Fig. 2 is a first schematic structural diagram of a reaction chamber provided by an embodiment of the present disclosure.
Fig. 3 is a second schematic structural diagram of a reaction chamber provided by an embodiment of the present disclosure.
Fig. 4 is a schematic diagram of a circuit structure of a monitoring module provided by an embodiment of the present disclosure.
Fig. 5 is a schematic diagram of a monitoring process provided by an embodiment of the present disclosure.
Fig. 6 is a first flow diagram of a film layer deposition method provided by an embodiment of the present disclosure.
Fig. 7 is a second flow diagram of a film layer deposition method provided by an embodiment of the present disclosure.

### Detailed Description of the Embodiments

Specific implementations of the present disclosure are explained in detail below with reference to accompanying drawings. It should be understood that the specific implementations described here are merely used to explain and illustrate the present disclosure, and not used to limit the present disclosure.

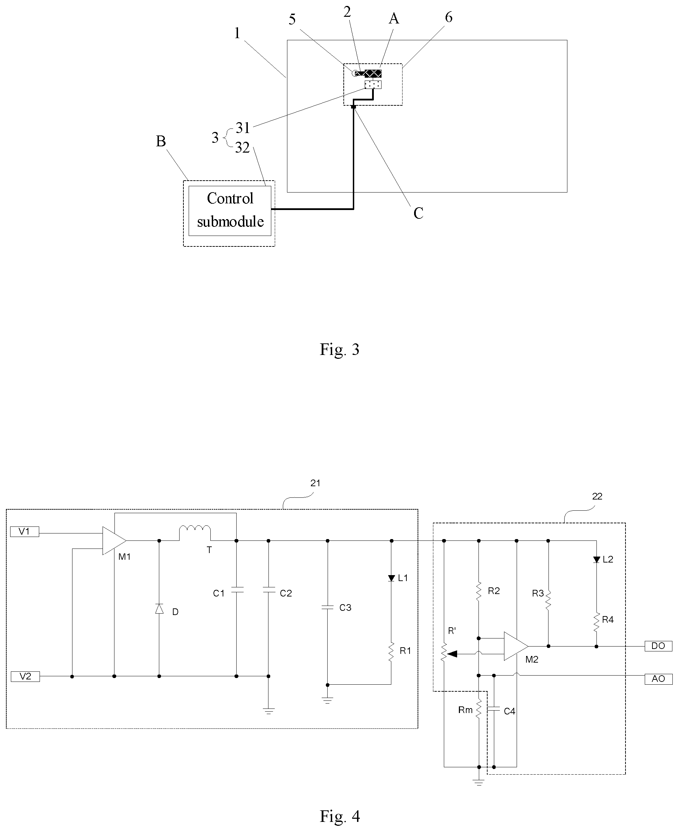

The present disclosure provides a reaction chamber of a semiconductor process device. Fig. 2 is a first schematic structural diagram of a reaction chamber provided by an embodiment of the present disclosure. Fig. 3 is a second schematic structural diagram of a reaction chamber provided by an embodiment of the present disclosure. In conjunction with Fig. 2 and Fig. 3, the reaction chamber includes: a chamber body 1, a monitoring module 2, a control module 3 and a deposition module 4, the deposition module 4 is configured to execute multiple deposition steps within a deposition period in the chamber body 1, and specifically, a supporting base 8 used for bearing a wafer 7 is arranged in the chamber body 1; the deposition module 4, for example, includes an air inlet apparatus 43 and an upper electrode apparatus; each of the deposition steps, for example, includes: the air inlet apparatus 43 configured to introduce a precursor into the chamber body 1; and the upper electrode apparatus configured to apply a radio frequency electric field to the chamber body 1, so as to motivate the precursor in the chamber body 1 to form plasma, thereby depositing a target film layer on the wafer 7. The monitoring module 2 is connected with the chamber body 1, and configured to monitor brightness of a plasma light source generated in the chamber body 1 when the deposition module 4 executes each deposition step, and generate a first signal according to the brightness of the plasma light source. Optionally, the monitoring module 2 may monitor the brightness of the plasma light source in real time, or may monitor the brightness of the plasma light source at a certain time interval. The control module 3 is configured to judge whether a thickness of a target film layer obtained after executing the multiple deposition steps is abnormal according to the first signal corresponding to the multiple deposition steps, and if yes, execute an abnormality processing flow.

In some optional embodiments, the above reaction chamber may be applied to a SiO₂ thin film deposition process, and includes a plasma enhanced atomic layer deposition (PEALD) process. The precursor may include source gas (such as bis(diethylamine)silane SAM24) and reaction gas (such as oxygen O₂). When the radio frequency electric field is applied to the upper electrode apparatus in the deposition module 4, the source gas in the precursor is motivated into plasma in the radio frequency electric field to emit light, so as to generate the plasma light source, if an ignition abnormality (such as an ignition failure) occurs when the radio frequency electric field is applied to the upper electrode apparatus, the brightness of the plasma light source in the chamber body 1 will be different from the brightness of the plasma light source during normal ignition, the monitoring module 2 may generate a first signal related to the brightness of the plasma light source, for example, the first signal may be a voltage signal, and the magnitude of the first signal is related to the brightness of the plasma light source.

In the embodiment of the present disclosure, the monitoring module 2 may generate the first signal in each deposition step, the control module 3 may judge whether the brightness of the plasma light source in the reaction chamber is abnormal (for example, the brightness is too low) according to the magnitude of the first signal generated in at least one of the deposition steps, if yes, it will be determined that the thickness of the deposited target film layer is abnormal.

By adopting the reaction chamber of the embodiment of the present disclosure, whether the thickness of the deposited target film layer is abnormal may be judged through the brightness of the plasma light source, and abnormality processing is performed in time when the thickness of the target film layer is abnormal, so as to improve a deviation between the thickness of the deposited target film layer and the target thickness.

The above abnormality processing flow includes:
sending, by the control module 3, an abnormality alerting signal; and/or, controlling the deposition module 4 to complementally execute at least one of the deposition steps.

By controlling the deposition module 4 to complementally execute at least one of the deposition steps, the thickness of the target film layer may be increased, so as to decrease the deviation between the thickness of the deposited target film layer and the target thickness.

The inventor founds in research that in the PEALD deposition process, a main factor causing the abnormality of the thickness of the target film layer is whether ignition of the deposition module 4 is normal, when the ignition of the deposition module 4 is normal, the SAM24 in the precursor in the reaction chamber may be broken into micromolecules, oxygen molecules may be motivated to form active oxygen atoms, oxygen radials and other multiple active groups, and the SAM24 micromolecules react with the active groups to form the target film layer. When the ignition of the deposition module 4 is abnormal, failure in the deposited target film layer is caused, and then the abnormal thickness of the target film layer is caused.

Therefore, when the ignition of the deposition module 4 is abnormal, it may be determined that the thickness of the target film layer is abnormal. Specifically, the control module 3 is configured to: judge whether a plasma ignition abnormality occurs in the deposition steps according to the first signal corresponding to at least one of the deposition steps, and if yes, determine that the thickness of the target film layer is abnormal, and execute an abnormality processing flow.

In some specific implementations, the first signal is the voltage signal negatively correlated to the brightness of the plasma light source in the reaction chamber. Fig. 4 is a schematic structural diagram of circuits of the monitoring module 2 provided by the embodiment of the present disclosure. As shown in Fig. 4, the monitoring module 2 includes a step-down circuit 21, a photoresistor Rm (photosensitive diode) and a signal generating circuit 22, the step-down circuit 21 is configured to reduce a 24 V voltage provided by a first voltage end V1 for being used by the signal generating circuit 22, a value of resistance of the photoresistor Rm is changed with the brightness of the plasma light source in the chamber body 1, and the signal generating circuit 22 is configured to generate a first signal according to the voltage signal generated by the step-down circuit 21 and the value of resistance of the photoresistor Rm. In the embodiment of the present disclosure, the first signal may be an analog signal, certainly, in order to enable an output signal to meet multiple requirements, the signal generating circuit 22 may further output a pulse signal in addition to outputting the analog signal, for example, as shown in Fig. 4, specifically:

In the embodiment of the present disclosure, the step-down circuit 21 includes a first comparator M1, a diode D, an inductor T, a first capacitor C1, a second capacitor C2, a third capacitor C3, a first light-emitting diode L1 and a first resistor R1. A first end of the first comparator M1 is connected with the first voltage end V1; a second end of the first comparator M1 is connected with a second voltage end V2; a third end of the first comparator M1 is connected with a second end of the inductor T, a second end of the first capacitor C1, a second end of the second capacitor C2, a second end of the third capacitor C3, and a first end of the first light-emitting diode L1; a fourth end of the first comparator M1 is connected with the second voltage end V2; an output end of the first comparator M1 is connected with a first end of the inductor T and a second end of the diode D; a first end of the diode D, a first end of the first capacitor C1 and a first end of the second capacitor C2 are all connected with the second voltage end V2; a first end of the third capacitor C3 and a first end of the first resistor R1 are both connected with a grounding end; and a second end of the first light-emitting diode L1 is connected with a second end of the first resistor R1.

The signal generating circuit 22 includes: a slide rheostat R', a second resistor R2, a third resistor R3, a fourth resistor R4, a fourth capacitor C4, a second comparator M2 and a second light-emitting diode L2. A first end of the second comparator M2 is connected with a first end of the second resistor R2, a second end of the photoresistor Rm, a second end of the fourth capacitor C4 and a first output end AO; a second end of the second comparator M2 is connected with a third end of the slide rheostat R'; and a third end of the second comparator M2 is connected with a second end of the slide rheostat R', a second end of the second resistor R2, a second end of the third resistor R3 and a first end of the second light-emitting diode L2. A fourth end of the second comparator M2 is connected with a first end of the slide rheostat R', a first end of the photoresistor Rm, and a first end of the fourth capacitor C4. An output end of the second comparator M2 is connected with a first end of the third resistor R3, the first end of the fourth resistor R4 and a second output end DO.

In the embodiment of the present disclosure, a voltage signal output from the first output end AO is the first signal, the higher the brightness of the plasma light source in the chamber body 1, the lower the value of resistance of the photoresistor Rm, the lower the divided voltage of the photoresistor Rm, and thus a lower analog signal is output from the first output end AO. The lower the brightness of the plasma light source in the chamber body 1, the higher the value of resistance of the photoresistor Rm, the higher the divided voltage of the photoresistor Rm, and thus a higher analog signal is output from the first output end AO.

The higher the brightness of the plasma light source in the chamber body 1, the lower the value of resistance of the photoresistor Rm, the lower the divided voltage of the photoresistor Rm, a voltage received at the first end of the second comparator M2 is lower, and when it is lower than a voltage received at the second end, the second comparator M2 outputs a low level, which indicates that the brightness of the plasma light source is normal. The lower the brightness of the plasma light source in the chamber body 1, the higher the value of resistance of the photoresistor Rm, the higher the divided voltage of the photoresistor Rm, the voltage received at the first end of the second comparator M2 is higher, and when it is higher than the voltage received at the second end, the second comparator M2 outputs a high level, which indicates that the brightness of the plasma light source is abnormal.

When the second comparator M2 outputs the low level, the second light-emitting transistor L2 may emit light, and when the second comparator M2 outputs the high level, the second light-emitting transistor L2 may be extinguished, so as to perform prompt.

It needs to be explained that in the above example, the second comparator M2 being an NPN type is taken as an example for illustration, which does not constitute limit of the type of the second comparator M2 in the embodiment of the present disclosure, and in practical products, the second comparator M2 may further adopt other types, which is not limited here.

In the embodiment of the present disclosure, a value of resistance of the slide rheostat R' is adjustable, so that the monitoring sensitivity may be adjusted.

In conjunction with Fig. 2 and Fig. 3, in some specific embodiments, the control module 3 includes: a processing submodule 31 and a control submodule 32, and the monitoring module 2 and the control submodule 32 are both connected with the processing submodule 31.

In the embodiment of the present disclosure, at least one of the monitoring module 2 and the processing submodule 31 may be integrated on a printed circuit board (PCB) A, is arranged on the chamber body 1, and is located outside the chamber body 1. The control submodule 32 may be integrated on a programmable logic controller (PLC) B. A length-width ratio of the printed circuit board A is set 5/3.

In some specific embodiments, the reaction chamber may further include a protective shell 6, and the protective shell 6 is arranged on a periphery of the printed circuit board A in a covering mode, so as to separate the printed circuit board A from the outside, thereby protecting the printed circuit board A. The printed circuit board A may be connected with the programmable logic controller B through signal lines. For example, a port used for transmitting a signal is formed in the protective shell 6, the printed circuit board A is connected with the port, the signal lines include a plug C, the signal lines are connected with the port formed in the protective shell 6 through the plug C, and thus the printed circuit board A is connected with the programmable logic controller B. The plug C of the signal lines may adopt a four-pin plug.

In the embodiment of the present disclosure, at least one of the monitoring module 2 and the processing submodule 31 is integrated on the printed circuit board A, the production cost may be reduced, and the arrangement convenience is improved.

In the embodiment of the present disclosure, the processing submodule 31 is configured to judge whether the first signal corresponding to each deposition step exceeds a preset range, and if yes, generate the second signal corresponding to the deposition step. The control submodule 32 is configured to count the number of times of generating, by the processing submodule 31, the second signal within the deposition period, and when the number of times of the second signal generated by the processing submodule 31 within the deposition period is greater than 0, determine that the thickness of the target film layer is abnormal, and execute an abnormality processing flow.

Optionally, if the first signal corresponding to each deposition step does not exceed the preset range, a third signal corresponding to the deposition step is generated.

In the embodiment of the present disclosure, the processing submodule 31 may include a filter circuit, and the preset range may be a range of the voltage signal corresponding to the brightness of the plasma light source in the chamber body 1 when the deposition module 4 is at normal ignition. The second signal and the third signal may be digital signals. For example, the second signal is a digital signal "1", and the third signal is a digital signal "0". When the control submodule 32 receives the second signal, the control submodule 32 may perform accumulative count, every time the second signal is received, a current accumulated value is +1, such that when the number of times (also namely accumulated value) of the second signal received by the control submodule 32 is greater than 0, it is illustrated that within the deposition period, in at least one of the deposition steps, the brightness of the plasma light source in the chamber body 1 is abnormal brightness, at the moment, the control submodule 32 determines that the thickness of the target film layer is abnormal, and then the abnormality processing flow is executed.

In some specific implementations, the deposition module 4 is connected with the control submodule 32. The above abnormality processing flow includes: the control submodule 32 controls the deposition module 4 to complementally execute at least one of the deposition steps according to the number of times of generating, by the processing submodule 31, the second signal within the deposition period. The flow may include: when the number of times of the second signal generated by the processing submodule 31 within the deposition period is greater than 0, the control submodule 32 controls the deposition module 4 to complementally execute at least one of the deposition steps according to the number of times of the second signal generated by the processing submodule 31 within the deposition period.

In the embodiment of the present disclosure, taking an example that the target film layer is the SiO₂ film layer and the target thickness is 13 Å, within one deposition period, when each deposition step is executed, the SiO₂ film layer with a certain thickness (such as 1 Å) is formed on the wafer 7, and within one deposition period, the SiO₂ film layer with the target thickness may be formed on the wafer 7 by executing the deposition steps of the predetermined number of times (such as 13). Within one deposition period, every time the second signal is generated by the processing submodule 31, it indicates that the ignition abnormality occurs when the radio frequency electric field is applied to the deposition module 4, the ignition abnormality of the deposition module 4 will cause that in the deposition step, a thickness of SiO₂ formed on the wafer 7 is smaller than 1 Å, then the thickness of the SiO₂ film layer formed finally is smaller than the target thickness, that is, the thickness of the target film layer is abnormal. Therefore, in the embodiment of the present disclosure, when the processing submodule 31 generates the second signal within the deposition period, the control submodule 32 controls the deposition module 4 to at least complementally execute one of the deposition steps, so as to compensate for the problem that the SiO₂ film layer is smaller than the target film layer caused by an ignition failure of the deposition module 4.

It should be understood that in the present disclosure, the complementally-executed deposition step is the same as the conventionally-executed deposition step within the deposition period, both include that precursor gas is introduced into the chamber body 1, and the radio frequency electric field is applied. The number of times of the control submodule 32 controlling the deposition module 4 to specifically complementally execute the deposition step may be determined according to practical requirements, for example, in some specific embodiments, the number of times of the deposition module 4 complementally executing the deposition step is the same as the number of times of the processing submodule 31 generating the second signal within the deposition period, so that the number of times of the deposition module 4 complementally executing the deposition step is the same as the number of times of the ignition abnormality of the deposition module 4 within the deposition period, and then the problem of a poor thickness of the SiO₂ film layer is compensated to the utmost extent.

In the present disclosure, the reaction chamber may monitor the deposition process and automatically compensate when the ignition abnormality occurs in the deposition module 4, so that the deviation between the thickness of the target film layer and the target thickness caused by the ignition abnormality of the deposition module 4 may be improved, and then the stability of a process result is improved, which is beneficial to improving the consistency of the thicknesses among film layers.

In some specific embodiments, a monitoring opening 5 is formed in a side wall of the chamber body 1, the monitoring module 2 is located outside the chamber body 1, and the monitoring module 2 monitors the brightness of the plasma light source in the chamber body 1 through the monitoring opening 5.

In some specific embodiments, the monitoring module 2 may cover the monitoring opening 5, so as to shield at least part of the monitoring opening 5, and ambient light is prevented from interfering with the monitoring module 2.

In some specific embodiments, a support base 8 used for bearing the wafer 7 is arranged in the reaction chamber, the upper electrode apparatus in the deposition module 4 includes an upper electrode 41 at a top of the chamber body 1 and an upper radio frequency power supply V connected with the upper electrode, and the upper radio frequency power supply V applies a radio frequency electric field to the chamber body 1 through the upper electrode 41.

Optionally, a lower electrode 42 is arranged in the support base 8, the lower electrode 42, for example, may be grounded, and the monitoring opening 5 is located between the lower electrode 42 and the upper electrode 41.

In some specific embodiments, the reaction chamber further includes an air inlet apparatus 43, and the air inlet apparatus 43 is configured to introduce a precursor into the chamber body 1. The upper electrode 41, the lower electrode 42 and the air inlet apparatus 43 may be connected with a programmable logic controller B, and execute the deposition steps under the control of the programmable logic controller B.

By the adoption of the reaction chamber of the embodiment of the present disclosure, the uniformity of the thickness of the film layer formed through deposition is <0.4%, and a thickness deviation is <0.4 Å, which has a better film forming quality.

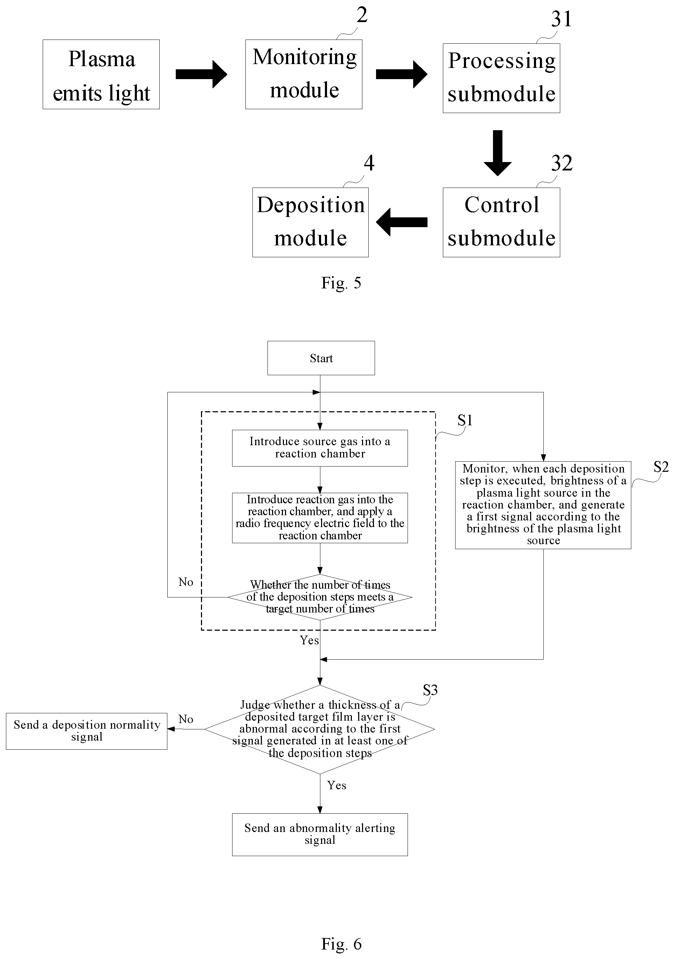

Fig. 5 is a schematic diagram of a monitoring process provided by an embodiment of the present disclosure, and the deposition process of the reaction chamber of the embodiment of the present disclosure is illustrated in conjunction with Fig. 2 to Fig. 5 below.

Before starting of the deposition process, an upper computer issues a process menu and a process starting instruction to the programmable logic controller B, the number of times of the deposition steps for meeting the target thickness requirements is recorded in the process menu, the programmable logic controller B controls the deposition module 4 to execute the deposition steps according to the process menu, and the upper computer gets into an idle state.

The deposition step may include the following steps:
Step one, the air inlet apparatus 43 introduces source gas (such as SAM24) into the chamber body 1, and the source gas is carried by inert gas (such as argon Ar) to enter the chamber body 1 and be adsorbed on a surface of the wafer 7. At the moment, the monitoring module 2 may start to monitor.
Step two, after the source gas is sufficiently adsorbed, purging gas is adopted to purge the chamber body 1 and the air inlet apparatus 43, so as to reduce residues of the source gas at other positions as much as possible.
Step three, the radio frequency power supply V is turned on to apply the radio frequency electric field between the upper electrode 41 and the lower electrode 42, meanwhile, reaction gas (such as oxygen O₂) is introduced, under the action of the radio frequency electric field, macromolecules of the source gas are broken into micromolecules, and the oxygen molecules are motivated to form active oxygen atoms, oxygen radicals and other multiple active groups. The broken micromolecules of the source gas react with the active groups of oxygen to form the SiO₂ film layer on the wafer 7.

In the step, the monitoring module 2 may output the first signal negatively correlated with the brightness of the plasma light source, the first signal may be the voltage signal, for example, if the ignition abnormality occurs in the deposition module 4, the brightness of the plasma light source in the chamber body 1 is lower, and the monitoring module 2 generates a larger first signal; and if the ignition abnormality does not occur to the deposition module 4, the brightness of the plasma light source in the chamber body 1 is higher, and the monitoring module 2 generates a smaller first signal. The processing submodule 31 processes the larger first signal into the second signal after filtering the first signal, and the second signal may be the digital signal "1".

Step four, the chamber body 1 and the air inlet apparatus 43 are purged again, until a complete deposition step is completed.

A second cycle is performed after one deposition step is completed, until the number of times of the deposition steps issued by the upper computer to the programmable logic controller B is completed, thus, it is a deposition period.

In the above deposition period, the control submodule 32 counts the number of times of the second signal generated by the processing submodule 31, after the above deposition period is completed, if the control submodule 32 counts that the number of times of the second signal generated by the processing submodule 31 is greater than 0, the control submodule 32 controls the deposition module 4 to complementally perform the above deposition step according to the number of times of the second signal generated by the processing submodule 31, the number of times of complement is the same as the number of times of the second signal generated by the processing submodule 31, and thus the deviation between the thickness of the SiO₂ film layer and the target thickness caused by the ignition abnormality is complemented. At the same time, the control submodule 32 further sends an ignition abnormality signal to the upper computer, the ignition abnormality signal may include the number of times of ignition abnormalities and the number of times of complementally executing the deposition step, and the upper computer may be continuously kept in the idle state after receiving the ignition abnormality signal and stops issuing a new instruction to the programmable logic controller B.

After the step of complementally executing the deposition step is completed, the programmable logic controller B may send a complement completing signal to the upper computer, and the upper computer stops the idle state and issues a new instruction after receiving the complement completing signal, so as to perform other process steps.

The present disclosure further provides a film layer deposition method. Fig. 6 is a first flow diagram of the film layer deposition method provided by the present disclosure. As shown in Fig. 6, the film layer deposition method includes:
S1, a deposition module 4 executes multiple deposition steps within a deposition period in a chamber body 1.

Specifically, each deposition step includes: a precursor is introduced into the chamber body 1, a radio frequency electric field is applied to a reaction chamber, so as to form a plasma light source in the reaction chamber, and a target film layer is deposited on a wafer through the plasma light source.

Specifically, the precursor includes source gas and reaction gas, in step S1, the source gas may be introduced into the reaction chamber firstly, after the source gas is sufficiently adsorbed on the surface of the wafer, the radio frequency electric field is applied to the reaction chamber, and meanwhile the reaction gas is introduced. When each deposition step is executed, whether the number of times of the deposition steps reaches a target number of times is judged, if yes, step S3 is executed, and if not, step S1 continues to be executed.

S2, When each deposition step is executed, the brightness of the plasma light source in the reaction chamber is monitored, and a first signal is generated according to the brightness of the plasma light source.

S3, Whether the thickness of the target film layer obtained after executing the multiple deposition steps is abnormal is judged according to the first signal corresponding to at least one deposition steps, and if yes, an abnormality processing flow is executed.

Optionally, if the thickness of the target film layer obtained after executing the multiple deposition steps is normal, a deposition normality signal may be sent, and a user and/or system are/is informed to perform a next process.

By adopting the film layer deposition method of the present disclosure, whether the thickness of the deposited target film layer is abnormal may be judged according to the brightness of the plasma light source, an abnormality alerting signal is sent after the thickness of the target film layer is abnormal, so as to complement the deposition step, and then a deviation between the thickness of the deposited film layer and a target thickness is improved.

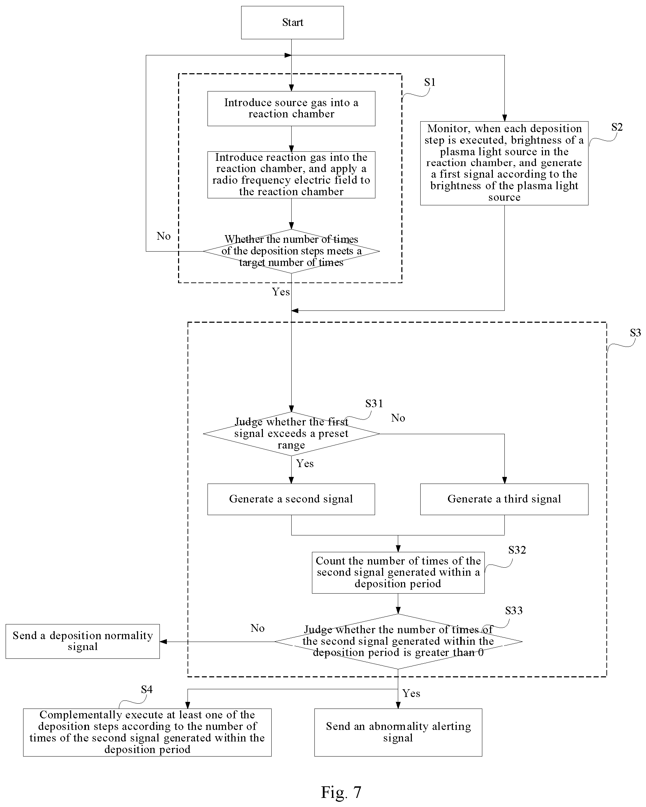

In some specific embodiments, the first signal is a voltage signal negatively correlated with the brightness of the plasma light source in the reaction chamber, Fig. 7 is a second flow diagram of a film layer deposition method provided by an embodiment of the present disclosure, and as shown in Fig. 7, step S3 includes:
S31, whether the first signal exceeds a preset range is judged, and if yes, a second signal is generated; and S32, the number of times of the second signal generated in the deposition period is counted.
S33, Whether the number of times of the second signal generated in the deposition period is greater than 0 is judged, if yes, it is determined that the thickness of the target film layer is abnormal, and the abnormality processing flow is executed.

Optionally, in step S31, if the first signal does not exceed the preset range, a third signal is generated. For example, the second signal and the third signal may be digital signals, for example, the second signal is the digital signal "1", and the third signal is the digital signal "0" .

In some specific embodiments, the film layer deposition method further includes:
S4, when the number of times of the second signal generated within the deposition period is greater than 0, at least one of the deposition steps is complementally executed according to the number of times of the second signal generated within the deposition period.

After the step of complementally executing the deposition step is completed, a complement completing signal may be sent, so as to perform other process steps.

In some specific embodiments, the number of times of complementally executing the deposition step is the same as the number of times of the second signal generated within the deposition period.

An embodiment of the present disclosure further provides a semiconductor process device, including the above reaction chamber. As shown in Fig. 2, a deposition module 4 includes an air inlet apparatus 43 and an upper electrode apparatus, and a support base 8 used for bearing a wafer is arranged in a chamber body 1; the air inlet apparatus 43 is configured to introduce a precursor into the chamber body 1; and the upper electrode apparatus is configured to motivate the precursor to form plasma.

Specifically, the above upper electrode apparatus may include an upper electrode 41 arranged at the top of the chamber body 1 and an upper radio frequency power supply V connected with the upper electrode, and the upper radio frequency power supply V loads a radio frequency electric field into the chamber body 1 through the upper electrode 41.

Optionally, a lower electrode 42 is arranged in the support base 8, for example, may be grounded.

It should be understood that the above implementations are merely exemplary implementations for illustrating the principle of the present disclosure, however, the present disclosure is not limited to them. For those skilled in the art, various changes and variations may be made without departing from the scope of the present disclosure, and these changes and variations are also regarded as the protection scope of the present disclosure.

## Claims

1. A reaction chamber of a semiconductor process device, the reaction chamber being configured to execute a plasma enhanced atomic layer deposition process, and comprising: a monitoring module, a deposition module, and a control module connected to the monitoring module; wherein,
the deposition module is configured to execute multiple deposition steps within a deposition period, the deposition module executing each of the multiple deposition steps comprising: introducing a precursor into the reaction chamber and applying a radio frequency electric field to the reaction chamber so as to form a plasma light source in the reaction chamber, and depositing a target film layer on a work piece to be processed through the plasma light source;
the monitoring module is configured to monitor brightness of the plasma light source in the reaction chamber when the deposition module executes each deposition step, and generate a first signal according to the brightness of the plasma light source; and
the control module is configured to judge whether a thickness of the target film layer deposited through the deposition module is abnormal according to the first signal generated in at least one of the deposition steps, and if yes, send an abnormality alerting signal, thereby enabling the control module to perform a compensation operation;
the control module is further configured to, when it is judged that the thickness of the target film layer is abnormal, control the deposition module to complementally execute at least one of the deposition steps; and
the control module is further configured to judge whether a plasma ignition abnormality occurs when the radio frequency electric field is applied by the deposition module according to the first signal generated in at least one of the deposition steps, and if yes, determine that the thickness of the target film layer is abnormal.

2. The reaction chamber according to claim 1, wherein the monitoring module comprises a photoresistor or a photosensitive diode, and the first signal is a voltage signal negatively correlated with the brightness of the plasma light source in the reaction chamber.

3. The reaction chamber according to claim 2, wherein the control module comprises: a processing submodule and a control submodule, and the monitoring module and the control submodule are both connected with the processing submodule;
the processing submodule is configured to judge whether the first signal exceeds a preset range, and if yes, generate a second signal; and
the control submodule is configured to count the number of times of generating, by the processing submodule, the second signal within the deposition period, and when the number of times of generating, by the processing submodule, the second signal within the deposition period is greater than 0, determine that the plasma ignition abnormality occurs when the radio frequency electric field is applied.

4. The reaction chamber according to claim 3, wherein the deposition module is connected with the control submodule,
the control submodule is further configured to control the deposition module to complementally execute at least one of the deposition steps according to the number of times of generating, by the processing submodule, the second signal within the deposition period, when the number of times of generating, by the processing submodule, the second signal within the deposition period is greater than 0.

5. The reaction chamber according to claim 4, wherein the number of times of complementally executing, by the deposition module, the deposition step is the same as the number of times of generating, by the processing submodule, the second signal within the deposition period.

6. The reaction chamber according to claim 1, wherein a support base for bearing the work piece to be processed is arranged in the reaction chamber, the deposition module comprises an upper electrode arranged at a top of the reaction chamber and a lower electrode arranged in the support base, the upper electrode and the lower electrode are configured to apply the radio frequency electric field in response to a driving signal, and the monitoring opening is located between the lower electrode and the upper electrode.

7. A semiconductor process device, comprising the reaction chamber according to any one of claims 1-6.

8. The semiconductor process device according to claim 7, wherein a monitoring opening is formed in a side wall of the reaction chamber, the monitoring module is located outside the reaction chamber, and the monitoring module monitors the brightness of the plasma light source in the reaction chamber through the monitoring opening.

9. A film layer deposition method, comprising the reaction chamber of the semiconductor process device according to any one of claims 1-6, and comprising:
executing multiple deposition steps within a deposition period, each of the multiple deposition steps comprising: introducing a precursor into the reaction chamber and applying a radio frequency electric field to the reaction chamber so as to form a plasma light source in the reaction chamber, and depositing a target film layer on a work piece to be processed through the plasma light source;
when each deposition step is executed, monitoring brightness of the plasma light source in the reaction chamber, and generating a first signal according to the brightness of the plasma light source; and
judging, according to the first signal generated in at least one of the deposition steps, whether a thickness of the deposited target film layer is abnormal, and if yes, sending an abnormality alerting signal.

10. The film layer deposition method according to claim 9, further comprising:
complementally executing at least one of the deposition steps when the thickness of the target film layer is abnormal.

## Patentansprüche

1. Reaktionskammer einer
Halbleiterverarbeitungsvorrichtung, wobei die Reaktionskammer konfiguriert ist, um einen plasmaunterstützten Atomlagenabscheidungsvorgang auszuführen, und aufweisend: ein Überwachungsmodul, ein Abscheidungsmodul und ein Steuermodul, das mit dem Überwachungsmodul verbunden ist; wobei
das Abscheidungsmodul konfiguriert ist, um mehrere Abscheidungsschritte innerhalb einer Abscheidungsperiode auszuführen, wobei das Ausführen jedes der mehreren Abscheidungsschritte durch das Abscheidungsmodul umfasst: Einführen eines Präkursors in die Reaktionskammer und Anlegen eines elektrischen Hochfrequenzfeldes an die Reaktionskammer, um eine Plasmalichtquelle in der Reaktionskammer zu bilden, und Abscheiden einer Zielfilmschicht auf einem zu bearbeitenden Werkstück durch die Plasmalichtquelle;
das Überwachungsmodul konfiguriert ist, um, bei Ausführung jedes Abscheidungsschritts durch das Abscheidungsmodul, die Helligkeit der Plasmalichtquelle in der Reaktionskammer zu überwachen und ein erstes Signal entsprechend der Helligkeit der Plasmalichtquelle zu erzeugen; und
das Steuermodul konfiguriert ist, um zu beurteilen, ob die Dicke der Zielfilmschicht, die durch das Abscheidungsmodul abgeschieden wird, entsprechend dem ersten Signal abnormal ist, das in mindestens einem der Abscheidungsschritte erzeugt wird, und wenn ja, ein Abnormalitätswarnsignal zu senden, so dass dadurch dem Steuermodul ermöglicht wird, einen Kompensationsvorgang durchzuführen;
das Steuermodul ferner konfiguriert ist, um, wenn beurteilt wird, dass die Dicke der Zielfilmschicht abnormal ist, das Abscheidungsmodul so zu steuern, dass es ergänzend mindestens einen der Abscheidungsschritte ausführt; und
das Steuermodul ferner konfiguriert ist, um zu beurteilen, ob eine Plasmazündungsanomalie auftritt, wenn das elektrische Hochfrequenzfeld durch das Abscheidungsmodul entsprechend dem ersten Signal, das in mindestens einem der Abscheidungsschritte erzeugt wird, angelegt wird, und wenn ja, zu bestimmen, dass die Dicke der Zielfilmschicht abnormal ist.

2. Reaktionskammer nach Anspruch 1, wobei das Überwachungsmodul einen Photowiderstand oder eine lichtempfindliche Diode aufweist und das erste Signal ein Spannungssignal ist, das mit der Helligkeit der Plasmalichtquelle in der Reaktionskammer negativ korreliert ist.

3. Reaktionskammer nach Anspruch 2, wobei das Steuermodul aufweist: ein Verarbeitungs-Submodul und ein Steuer-Submodul, und das Überwachungsmodul und das Steuer-Submodul beide mit dem Verarbeitungs-Submodul verbunden sind;
das Verarbeitungs-Submodul konfiguriert ist, um zu beurteilen, ob das erste Signal einen voreingestellten Bereich überschreitet, und wenn ja, ein zweites Signal zu erzeugen; und
das Steuer-Submodul konfiguriert ist, um die Anzahl von Erzeugungen des zweiten Signals durch das Verarbeitungs-Submodul innerhalb der Abscheidungsperiode zu zählen, und wenn die Anzahl von Erzeugungen des zweiten Signals durch das Verarbeitungs-Submodul innerhalb der Abscheidungsperiode größer als 0 ist, zu bestimmen, dass die Plasmazündungsanomalie auftritt, wenn das elektrische Hochfrequenzfeld angelegt wird.

4. Reaktionskammer nach Anspruch 3, wobei das Abscheidungsmodul mit dem Steuer-Submodul verbunden ist,
das Steuer-Submodul ferner konfiguriert ist, um das Abscheidungsmodul so zu steuern, dass es entsprechend der Anzahl von Erzeugungen des zweiten Signals durch das Verarbeitungs-Submodul innerhalb der Abscheidungsperiode ergänzend mindestens einen der Abscheidungsschritte ausführt, wenn die Anzahl von Erzeugungen des zweiten Signals durch das Verarbeitungs-Submodul innerhalb der Abscheidungsperiode größer als 0 ist.

5. Reaktionskammer nach Anspruch 4, wobei die Anzahl von ergänzenden Ausführungen des Abscheidungsschritts durch das Abscheidungsmodul gleich der Anzahl von Erzeugungen des zweiten Signals durch das Verarbeitungs-Submodul innerhalb der Abscheidungsperiode ist.

6. Reaktionskammer nach Anspruch 1, wobei eine Trägerbasis zum Tragen des zu bearbeitenden Werkstücks in der Reaktionskammer angeordnet ist, das Abscheidungsmodul eine obere Elektrode, die an einer Oberseite der Reaktionskammer angeordnet ist, und eine untere Elektrode, die in der Trägerbasis angeordnet ist, aufweist, die obere Elektrode und die untere Elektrode konfiguriert sind, um das elektrische Hochfrequenzfeld als Reaktion auf ein Ansteuersignal anzulegen, und die Überwachungsöffnung zwischen der unteren Elektrode und der oberen Elektrode angeordnet ist.

7. Halbleiterverarbeitungsvorrichtung, die Reaktionskammer nach einem der Ansprüche 1 bis 6 aufweisend.

8. Halbleiterverarbeitungsvorrichtung nach Anspruch 7, wobei eine Überwachungsöffnung in einer Seitenwand der Reaktionskammer gebildet ist, das Überwachungsmodul außerhalb der Reaktionskammer angeordnet ist und das Überwachungsmodul die Helligkeit der Plasmalichtquelle in der Reaktionskammer durch die Überwachungsöffnung überwacht.

9. Filmschichtabscheidungsverfahren, die Reaktionskammer der Halbleiterverarbeitungsvorrichtung nach einem der Ansprüche 1 bis 6 aufweisend, und Folgendes umfassend:
Ausführen mehrerer Abscheidungsschritte innerhalb einer Abscheidungsperiode, wobei jeder der mehreren Abscheidungsschritte umfasst: Einführen eines Präkursors in die Reaktionskammer und Anlegen eines elektrischen Hochfrequenzfeldes an die Reaktionskammer, um eine Plasmalichtquelle in der Reaktionskammer zu bilden, und Abscheiden einer Zielfilmschicht auf einem zu bearbeitenden Werkstück durch die Plasmalichtquelle;
bei Ausführung jedes Abscheidungsschritts, Überwachen der Helligkeit der Plasmalichtquelle in der Reaktionskammer und Erzeugen eines ersten Signals entsprechend der Helligkeit der Plasmalichtquelle; und
Beurteilen, entsprechend dem ersten Signal, das in mindestens einem der Abscheidungsschritte erzeugt wird, ob eine Dicke der abgeschiedenen Zielfilmschicht abnormal ist, und wenn ja, Senden eines Abnormalitätswarnsignals.

10. Filmschichtabscheidungsverfahren nach Anspruch 9, ferner umfassend:
ergänzendes Ausführen mindestens eines der Abscheidungsschritte, wenn die Dicke der Zielfilmschicht abnormal ist.

## Revendications

1. Chambre de réaction d'un dispositif de traitement des semi-conducteurs, la chambre de réaction étant configurée pour exécuter un processus de dépôt par couche atomique amélioré par plasma, et comprenant : un module de surveillance, un module de dépôt, et un module de commande connecté au module de surveillance ; dans lequel,
le module de dépôt est configuré pour exécuter plusieurs étapes de dépôt au cours d'une période de dépôt, le module de dépôt exécutant chacune des multiples étapes de dépôt comprenant : l'introduction d'un précurseur dans la chambre de réaction et l'application d'un champ électrique radiofréquence à la chambre de réaction de manière à former une source de lumière plasma dans la chambre de réaction, et le dépôt d'une couche de film cible sur une pièce de travail à traiter à travers la source de lumière plasma ;
le module de surveillance est configuré pour surveiller la luminosité de la source de lumière plasma dans la chambre de réaction lorsque le module de dépôt exécute chaque étape de dépôt, et pour générer un premier signal en fonction de la luminosité de la source de lumière plasma ; et
le module de commande est configuré pour juger si une épaisseur de la couche de film cible déposée par le module de dépôt est anormal selon le premier signal généré dans au moins une des étapes de dépôt, et si oui, envoyer un signal d'alerte d'anomalie, permettant ainsi au module de commande d'effectuer une opération de compensation ;
le module de commande est en outre configuré pour, lorsqu'il est jugé que l'épaisseur de la couche cible est anormale, commander le module de dépôt pour qu'il exécute en complément au moins l'une les étapes de dépôt ; et
le module de commande est en outre configuré pour juger si une anomalie d'allumage du plasma se produit lorsque le champ électrique radiofréquence est appliqué par le module de dépôt en fonction du premier signal généré dans au moins une des étapes de dépôt, et si oui, déterminer que l'épaisseur de la couche de film cible est anormale.

2. Chambre de réaction selon la revendication 1, dans laquelle le module de surveillance comprend une photorésistance ou une diode photosensible, et le premier signal est un signal de tension négativement corrélé avec la luminosité de la source de lumière plasma dans la chambre de réaction.

3. Chambre de réaction selon la revendication 2, dans laquelle le module de commande comprend : un sous-module de traitement et un sous-module de commande, et le module de surveillance et le sous-module de commande sont, tous deux reliés au sous-module de traitement,
le sous-module de traitement est configuré pour juger si le premier signal dépasse une plage prédéfinie et, dans l'affirmative, générer un second signal ; et
le sous-module de commande est configuré pour compter le nombre de fois où le sous-module de traitement génère le deuxième signal pendant la période de dépôt et, lorsque le nombre de fois où le sous-module de traitement génère le deuxième signal pendant la période de dépôt est supérieur à 0, pour déterminer que l'anomalie d'allumage du plasma se produit lorsque le champ électrique radiofréquence est appliqué.

4. Chambre de réaction selon la revendication 3, dans laquelle le module de dépôt est relié au sous-module de commande,
le sous-module de commande est en outre configuré pour commander au module de dépôt l'exécution complémentaire d'au moins une des étapes de dépôt en fonction du nombre de fois où le second signal a été généré par le sous-module de traitement, au cours de la période de dépôt, lorsque le nombre de fois où le sous-module de traitement génère le deuxième signal pendant la période de dépôt est supérieur à 0.

5. Chambre de réaction selon la revendication 4, dans laquelle le nombre de fois où le module de dépôt exécute complémentairement l'étape de dépôt est le même que le nombre de fois où le second signal est généré par le sous-module de traitement pendant la période de dépôt.

6. Chambre de réaction selon la revendication 1, dans laquelle une base de support pour la pièce de travail à traiter est disposée dans la chambre de réaction, le module de dépôt comprend une électrode supérieure disposée au sommet de la chambre de réaction et une électrode inférieure disposée dans la base de support, l'électrode supérieure et l'électrode inférieure sont configurées pour appliquer le champ électrique radiofréquence en réponse à un signal de commande, et l'ouverture de contrôle est située entre l'électrode inférieure et l'électrode supérieure.

7. Dispositif de traitement des semi-conducteurs comprenant la chambre de réaction selon l'une des revendications 1 à 6.

8. Dispositif de traitement des semi-conducteurs selon la revendication 7, dans lequel une ouverture de contrôle est formé dans une paroi latérale de la chambre de réaction, le module de surveillance est situé à l'extérieur de la chambre de réaction, et le module de surveillance surveille la luminosité de la source de lumière plasma dans la chambre de réaction à travers l'ouverture de surveillance.

9. Méthode de dépôt d'une couche de film, comprenant la chambre de réaction d'un dispositif de traitement des semi-conducteurs selon l'une des revendications 1 à 6, et comprenant :
exécuter plusieurs étapes de dépôt au cours d'une période de dépôt, chacune des multiples étapes de dépôt comprenant : introduire un précurseur dans la chambre de réaction et appliquer un champ électrique radiofréquence à la chambre de réaction de manière à former une source de lumière plasma dans la chambre de réaction, et déposer une couche de film cible sur une pièce de travail à traiter par l'intermédiaire de la source de lumière plasma ;
lors de l'exécution de chaque étape de dépôt, surveiller la luminosité de la source de lumière plasma dans la chambre de réaction et générer un premier signal en fonction de la luminosité de la source de lumière plasma ; et
juger, en fonction du premier signal généré dans au moins une des étapes de dépôt, si l'épaisseur de la couche de film cible déposée est anormal, et si oui, envoyer un signal d'alerte d'anomalie.

10. Méthode de dépôt de couche de film selon la revendication 9, comprenant en outre :
l'exécution complémentaire d'au moins une des étapes de dépôt lorsque l'épaisseur de la cible est anormale.
